# EUROPEAN PATENT APPLICATION

(11) **EP 4 060 076 A1**
(43) Date of publication of application: **21.09.2022**
(21) Application number: 20888253.0
(22) Date of filing: 04.11.2020
(51) Int. Cl.: C23C 16/44, H01L 21/205

(54) **ADHERED SUBSTANCE REMOVING METHOD AND FILM-FORMING METHOD**

(30) Priority: 12.11.2019 JP 2019204954
(71) Applicant: Showa Denko K.K., Tokyo 105-8518 (JP)
(72) Inventor: TANIMOTO, Yosuke, Tokyo 105-8518 (JP)
(74) Representative: Strehl Schübel-Hopf & Partner
(86) International application number: PCT/JP2020/041239
(87) International publication number: WO 2021/095608

(57) **Abstract**

Provided are a deposit removal method and a film deposition method capable of removing a selenium-containing deposit adhering to an inner surface of a chamber or an inner surface of piping connected to the chamber without disassembling the chamber. A selenium-containing deposit adhering to at least one of the inner surface of a chamber (10) or the inner surface of exhaust piping (15) connected to the chamber (10) is removed by reacting with a cleaning gas containing a hydrogen-containing compound gas.

## Description

### Technical Field

The present invention relates to a deposit removal method and a film deposition method.

### Background Art

In recent years, the semiconductor field has been paying attention to semiconductor materials containing elements other than silicon (Si). Examples of the semiconductor materials containing elements other than silicon include semiconductor materials containing group III to V elements, such as germanium (Ge) and indium gallium arsenide (InGaAs), and semiconductor materials containing metal chalcogenide.

These semiconductor materials are advantageous in that they have higher mobility (moving speed) than silicon materials, but may have difficulty in film deposition and have a high defect density at an interface between materials.

Accordingly, in order to reduce the defect density at the interface between materials, there has been proposed a method for forming a passivation film on a substrate made of germanium, molybdenum, or the like using hydrogen selenide (H₂Se) gas (see, for example, PTL 1). Additionally, as a method for depositing a metal chalcogenide film, a method for forming a molybdenum selenide layer or a tungsten selenide layer by treating a molybdenum oxide layer or a tungsten oxide layer with a radicalized hydrogen selenide gas has been proposed (see, for example, PTL 2).

### Citation List

### Patent Literature

PTL 1: JP 2016-207789 A
PTL 2: JP 2017-061743 A
PTL 3: JP 2011-066450 A

### Summary of Invention

### Technical Problem

In the above method for reducing the defect density at the interface between materials, reaction is performed under high temperature conditions, due to which a selenium-containing deposit produced by decomposition of hydrogen selenide may adhere to an inner surface of a chamber in which the reaction is performed or an inner surface of piping located on a downstream side of the chamber.

When a substrate such as a wafer is introduced into the chamber with the selenium-containing deposit adhering to the inner surface of the chamber or the inner surface of the piping located on the downstream side of the chamber, selenium particles may adhere to the substrate such as a wafer when the inside of the chamber is evacuated and replaced with inert gas. Then, the adhesion of the selenium particles to the substrate may degrade the performance of a manufactured semiconductor structure.

For example, PTL 3 discloses a technology for etching a chalcogen compound semiconductor film including selenium using a plasma etching device. In this technology, since etching product-derived selenium adheres to the inner surface of a chamber, the adhering selenium is removed by plasma cleaning with a cleaning gas containing boron trichloride (BCl₃) and chlorine (Cl₂).

In the technology disclosed in PTL 3, selenium is removed by reacting with chlorine. However, selenium chloride, which is a reaction product, is in solid form depending on the oxidation number of selenium, so that the selenium chloride adheres again to another place in the plasma etching device or adheres again to piping located on a downstream side of the plasma etching device, which is problematic. Therefore, when a deposit containing the selenium chloride adheres to the inner surface of the chamber or the inner surface of the piping located on the downstream side of the chamber, the chamber is needed to be disassembled for cleaning.

It is an object of the present invention to provide a deposit removal method and a film deposition method that are capable of removing a selenium-containing deposit adhering to the inner surface of a chamber or the inner surface of piping connected to the chamber without disassembling the chamber.

### Solution to Problem

In order to achieve the above object, an aspect of the present invention is as follows: [1] to [6].
[1] A deposit removal method including removing a selenium-containing deposit adhering to at least one of an inner surface of a chamber or an inner surface of piping connected to the chamber by reacting the deposit with a cleaning gas containing a hydrogen-containing compound gas.
[2] The deposit removal method according to [1], in which the cleaning gas is brought into contact with the deposit under conditions of a temperature of from 20°C to 800°C and a pressure of from 20 Pa to 101 kPa.
[3] The deposit removal method according to [1] or [2], in which the hydrogen-containing compound gas is at least one selected from a group consisting of hydrogen gas, hydrocarbon gas, and ammonia gas.
[4] The deposit removal method according to [1] or [2], in which the hydrogen-containing compound gas is hydrogen gas.
[5] A film deposition method including a passivation step of supplying a passivation gas containing a selenium-containing compound gas to a chamber housing a substrate and reacting the substrate with the passivation gas to deposit a passivation film on a surface of the substrate and a deposit removal step of, after performing the passivation step, removing a selenium-containing deposit adhering to at least one of an inner surface of the chamber or an inner surface of piping connected to the chamber, in which the deposit removal step is performed by the deposit removal method according to any one of [1] to [4].
[6] The film deposition method according to [5], in which the selenium-containing compound gas is hydrogen selenide gas.

### Advantageous Effects of Invention

According to the present invention, the selenium-containing deposit adhering to the inner surface of the chamber or the inner surface of the piping connected to the chamber can be removed without disassembling the chamber. Brief Description of Drawings

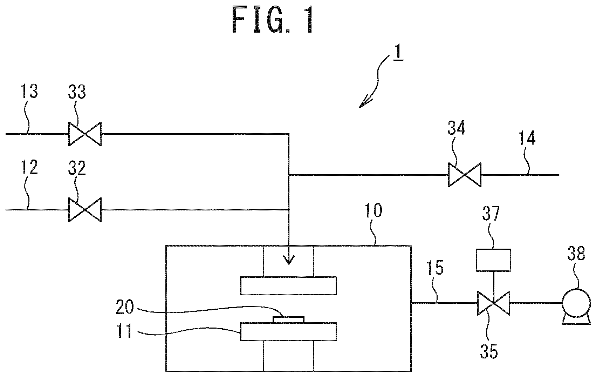

FIG. 1 is a schematic diagram of a film deposition system illustrating an embodiment of a film deposition method according to the present invention.

### Description of Embodiments

An embodiment of the present invention will be described hereinbelow. It should be noted that the present embodiment is illustrative of an example of the present invention, and the present invention is not limited thereto. Additionally, various changes or improvements can be added to the present embodiment, and embodiments added with such changes or improvements may also be included in the present invention.

### [First Embodiment]

A first embodiment of the present invention is an embodiment of a deposit removal method, which is a method comprising removing a selenium-containing deposit (hereinafter may also be referred to simply as "deposit") adhering to at least one of an inner surface of a chamber or an inner surface of piping connected to the chamber by reacting with a cleaning gas containing a hydrogen-containing compound gas. Note that the hydrogen-containing compound gas and the cleaning gas contain no selenium atoms.

In cases such as performing a reaction using selenium in a chamber, a selenium-containing deposit may adhere to the inner surface of the chamber or the inner surface of piping connected to the chamber (for example, cleaning gas supply piping connected to an upstream side of the chamber or exhaust piping connected to a downstream side of the chamber). If the next reaction is performed with the deposit adhering thereto, the reaction may be affected negatively. Therefore, it is preferable to perform the next reaction after removing the deposit.

The deposit removal method according to the first embodiment removes the deposit by bringing the deposit into contact with the cleaning gas and reacting the selenium contained in the deposit with the hydrogen-containing compound gas contained in the cleaning gas to produce hydrogen selenide gas. Accordingly, the deposit adhering to the inner surface of the chamber or the inner surface of the piping connected to the chamber can be removed without disassembling the chamber. This can facilitate removal of the deposit.

The contact between the cleaning gas and the deposit is performed under conditions of a temperature of preferably from 20°C to 800°C, and more preferably from 40°C to 600°C. When the temperature is 800°C or lower, the hydrogen-containing compound gas in the cleaning gas and the produced hydrogen selenide gas are unlikely to corrode metal materials such as stainless steel forming the chamber and the piping, as well as it is unlikely that there occurs a reverse reaction in which the hydrogen selenide gas produced by the reaction of the selenium in the deposit with the hydrogen-containing compound gas in the cleaning gas reverts to selenium. On the other hand, at temperatures of 20°C or higher, the reaction of the selenium in the deposit with the hydrogen-containing compound gas in the cleaning gas is easy to proceed.

Additionally, the contact between the cleaning gas and the deposit is performed under conditions of an absolute pressure of preferably from 20 Pa to 101 kPa, and more preferably from 60 Pa to 90 kPa. When the pressure is 101 kPa or lower, it is unlikely that defects occur in the chamber and the piping. For example, when the chamber is a reaction vessel for a film deposition system that deposits a passivation film on a surface of a substrate by reacting the substrate with a passivation gas, it must be used in a decompressed environment, and therefore the pressure conditions are preferably 101 kPa or lower. On the other hand, at pressures of 20 Pa or higher, the reaction of the selenium in the deposit with the hydrogen-containing compound gas in the cleaning gas is easy to proceed.

The hydrogen-containing compound gas is a gas of a compound including a hydrogen atom, and more specifically, a gas not including selenium and halogen atoms. Examples thereof include hydrogen gas (H₂), hydrocarbon gas, and ammonia gas (NH₃). Among them, preferred is at least one type of gas selected from a group consisting of hydrogen gas (H₂), methane gas (CH₄), ethane gas (C₂H₆), propane gas (C₃H₈), butane gas (C₄H₁₀), and ammonia gas (NH₃), and more preferred is at least one of hydrogen gas or methane gas.

Hydrogen gas reacts with selenium at a temperature of 300°C or higher under a pressure of 101 kPa. Therefore, when the cleaning gas contains hydrogen gas, it is preferable to bring the cleaning gas into contact with selenium (the deposit) at a temperature of from 300°C to 800°C. Note that when hydrogen gas is contained in the cleaning gas, it is preferable to remove the deposit while heating an inside of the chamber and the piping in order to efficiently remove the deposit. Additionally, in order to increase reactivity between methane gas and selenium, a temperature of 300°C or higher is preferable. Thus, when methane gas is contained in the cleaning gas, it is preferable to bring the cleaning gas into contact with selenium (the deposit) at a temperature of from 300°C to 800°C.

The content ratio of the hydrogen-containing compound gas in the cleaning gas is not particularly limited as long as it is an amount sufficient to remove selenium (the deposit), but is preferably 5% by volume or more, more preferably 20% by volume or more, still more preferably 90% by volume or more, and particularly preferably 100% by volume. Any component other than the hydrogen-containing compound gas contained in the cleaning gas is not particularly limited as long as it is a gas of a compound including no selenium atoms. Examples thereof include an inert gas such as nitrogen gas or argon gas.

The chamber is not particularly limited as long as it is made of a material having resistance to hydrogen selenide. The chamber preferably has a structure that can be depressurized to a predetermined pressure, and examples of the material include aluminum having an anodized surface. Additionally, the piping connected to the chamber is also not particularly limited as long as it is made of a material having resistance to hydrogen selenide, but preferably has a structure that can withstand a predetermined pressure. The deposit removal method according to the first embodiment can be suitably applied to, for example, a chamber included as a reaction vessel in a semiconductor film deposition system and piping connected to the chamber.

### [Second Embodiment]

A second embodiment of the present invention is an embodiment of a film deposition method, which is a method comprising a passivation step of supplying a passivation gas containing a selenium-containing compound gas to a chamber housing a substrate and reacting the substrate with the passivation gas to deposit a passivation film on a surface of the substrate and a deposit removal step of, after performing the passivation step, removing a selenium-containing deposit adhering to at least one of an inner surface of the chamber or an inner surface of piping connected to the chamber. Additionally, the deposit removal step is performed by the deposit removal method of the first embodiment.

In the passivation step of depositing a passivation film on the surface of a substrate using a passivation gas, a selenium-containing deposit may adhere to the inner surface of the chamber or the inner surface of the piping connected to the chamber (for example, gas supply piping for the passivation gas or the cleaning gas connected to the upstream side of the chamber or exhaust piping connected to the downstream side of the chamber).

When the substrate is introduced into the chamber with the deposit adhering to the inner surface of the chamber or the inner surface of the piping, selenium particles may adhere to the substrate when the inside of the chamber is evacuated and replaced with inert gas. Then, the adhesion of the selenium particles to the substrate may degrade the performance of a manufactured semiconductor structure. In addition, when the next passivation step is performed in a state where the selenium particles remain adhering to the substrate, there may occur defects such as decreases in the film deposition rate and film quality of the passivation film. Therefore, it is preferable to perform the next passivation step after removing the deposit.

In the film deposition method according to the second embodiment, the deposit is removed by bringing the deposit into contact with the cleaning gas and reacting the selenium in the deposit with the hydrogen-containing compound gas in the cleaning gas to produce hydrogen selenide gas. Accordingly, the deposit adhering to the inner surface of the chamber or the inner surface of the piping connected to the chamber can be removed without disassembling the chamber. This can facilitate the removal of the deposit. Additionally, since the film deposition method according to the second embodiment would be able to suppress the adhesion of selenium particles to the substrate by the removal of the deposit, a semiconductor structure having excellent performance can be manufactured.

Note that in the film deposition method according to the second embodiment, the deposit removal step does not necessarily have to be performed every time the passivation step is performed. The deposit removal step may be performed every time the passivation step is performed a plurality of times. Reducing the number of times the deposit removal step is performed relative to the number of times the passivation step is performed can improve the efficiency of using the film deposition system.

The type of the passivation gas containing the selenium-containing compound gas is not particularly limited as long as it is a gas of a compound including selenium, but preferred is hydrogen selenide gas because of its favorable passivation performance.

The content ratio of the selenium-containing compound gas in the passivation gas is not particularly limited as long as it is an amount sufficient to deposit the passivation film. The content ratio thereof is preferably 1% by volume or more, more preferably 2% by volume or more, still more preferably 10% by volume or more, and particularly preferably 100% by volume. Any component other than the selenium-containing compound gas contained in the passivation gas is not particularly limited, and examples thereof include an inert gas such as nitrogen gas or argon gas.

The type of the material forming the substrate is not particularly limited as long as it is a semiconductor material. Examples thereof include materials containing elements such as silicon, germanium, group III to V compounds, molybdenum, and tungsten. As silicon, silicon used in the formation of semiconductor devices is suitable, and examples thereof include amorphous silicon, polysilicon, and single crystal silicon. For germanium, group III to V compounds, molybdenum, and tungsten as well, those used in the formation of semiconductor devices are suitable.

The pressure in the chamber when depositing the passivation film in the passivation step is not particularly limited, but is preferably from 1 Pa to 101 kPa, more preferably from 10 Pa to 90 kPa, and still more preferably from 100 Pa to 80 kPa.

The temperature of the substrate when reacting the substrate with the passivation gas in the passivation step, is not particularly limited. However, in order to obtain high in-plane uniformity of the treatment of the substrate surface with the passivation gas, the temperature of the substrate is preferably from 20°C to 1500°C, more preferably from 50°C to 1200°C, and still more preferably from 100°C to 1000°C.

The length of the passivation time in the passivation step is not particularly limited, but is preferably within 120 minutes in consideration of the efficiency of a semiconductor device manufacturing process. Note that the passivation time refers to a time from when the passivation gas is introduced into the chamber housing the substrate to when the passivation gas in the chamber is exhausted by a vacuum pump or the like in order to finish the treatment of the substrate surface with the passivation gas.

The film deposition method according to the second embodiment can be suitably applied to a semiconductor film deposition system that deposits a passivation film on a substrate surface. The structure of the film deposition system is not particularly limited, and a positional relationship between the substrate housed in the chamber being a reaction vessel and the piping connected to the chamber is also not particularly limited.

### Examples

The present invention will be described in more detail with reference to Examples and Comparative Examples illustrated below.

### (Example 1)

Using a film deposition system 1 illustrated in FIG. 1, the passivation step of forming a passivation film on the surface of a substrate and the deposit removal step of removing a selenium-containing deposit were repeatedly performed. The film deposition system 1 includes a chamber 10 in which the passivation step and the deposit removal step are performed and a temperature control device (unillustrated) for controlling the temperature of an inside of the chamber 10. The inside of the chamber 10 is provided with a stage 11 that supports a sample 20. As the sample 20 used, a silicon oxide film having a thickness of 150 nm was formed on a silicon substrate, and additionally, a molybdenum film having a thickness of 80 nm was formed on the silicon oxide film.

Passivation gas supply piping 12 that supplies a passivation gas containing a selenium-containing compound gas to the chamber 10, cleaning gas supply piping 13 that supplies a cleaning gas containing a hydrogen-containing compound gas to the chamber 10, and inert gas supply piping 14 that supplies an inert gas to the chamber 10 are connected to an upstream side of the chamber 10 via valves 32, 33, and 34, respectively.

Furthermore, exhaust piping 15 that exhausts the gas in the chamber 10 to an outside thereof is connected to a downstream side of the chamber 10, and a vacuum pump 38 is connected to the downstream side of the exhaust piping 15 via a valve 35. The pressure in the chamber 10 is controlled by a pressure controller 37 that controls the valve 35.

First, the passivation step was performed using the film deposition system 1 configured as above. The sample 20 was placed on the stage 11, and after reducing the pressure in the chamber 10 to less than 10 Pa, the temperature in the chamber 10 was raised to 800°C. After that, the valve 32 was opened, and as a passivation gas, hydrogen selenide gas was supplied into the chamber 10 from the passivation gas supply piping 12 at a pressure of 101 kPa. The flow rate of the passivation gas at this time was 100 sccm, and the pressure in the chamber 10 when depositing a passivation film on a surface of the sample 20 was 67 kPa. Note that sccm represents a flow rate (mL/min) at 0°C and 101.3 kPa.

The passivation gas was introduced for 30 minutes, and the surface of the sample 20 was selenized under conditions of a temperature of 800°C and a pressure of 67 kPa to deposit a passivation film, after which the introduction of the passivation gas was stopped. Then, the inside of the chamber 10 was evacuated by the vacuum pump 38, then the inert gas was supplied into the chamber 10 from the inert gas supply piping 14, and the inside of the chamber 10 was replaced with the inert gas. After that, the temperature in the chamber 10 was lowered to room temperature, and the sample 20 deposited with the passivation film was taken out from the chamber 10.

Next, the deposit removal step was performed using the film deposition system 1. After reducing the pressure in the chamber 10 from which the sample 20 was taken out to less than 10 Pa, the temperature in the chamber 10 was raised to 500°C. After that, the valve 33 was opened, and as a cleaning gas, hydrogen gas was supplied to the inside of the chamber 10 and the exhaust piping 15 from the cleaning gas supply piping 13. The flow rate of the cleaning gas at this time was 100 sccm, and the pressure in the chamber 10 when removing the deposit was 67 kPa.

The cleaning gas was introduced for 5 minutes, and the deposit was reacted with the hydrogen gas under conditions of a temperature of 500°C and a pressure of 67 kPa to remove the deposit, after which the introduction of the cleaning gas was stopped. Then, the inside of the chamber 10 was evacuated by the vacuum pump 38, the inert gas was supplied into the chamber 10 from the inert gas supply piping 14, and the inside of the chamber 10 was replaced with the inert gas.

When the deposit removal step was completed, the passivation step was performed in the same manner as above to deposit a passivation film on a new sample 20. Then, the deposit removal step was performed in the same manner as above. These operations were repeated to manufacture a total of 100 samples 20 deposited with a passivation film.

### (Example 2)

One hundred samples 20 deposited with a passivation film were manufactured in the same manner as in Example 1 except that the temperature and pressure in the chamber 10 in the deposit removal step were 350°C and 100 Pa.

### (Example 3)

One hundred samples 20 deposited with a passivation film were manufactured in the same manner as in Example 1 except that the temperature in the chamber 10 in the deposit removal step was 20°C.

### (Example 4)

One hundred samples 20 deposited with a passivation film were manufactured in the same manner as in Example 1 except that the temperature in the chamber 10 in the deposit removal step was 800°C.

### (Example 5)

One hundred samples 20 deposited with a passivation film were manufactured in the same manner as in Example 1 except that the pressure in the chamber 10 in the deposit removal step was 20 Pa.

### (Example 6)

One hundred samples 20 deposited with a passivation film were manufactured in the same manner as in Example 1 except that the pressure in the chamber 10 in the deposit removal step was 101 kPa.

### (Example 7)

One hundred samples 20 deposited with a passivation film were manufactured in the same manner as in Example 1 except that the cleaning gas supplied from the cleaning gas supply piping 13 in the deposit removal step was methane gas.

### (Example 8)

One hundred samples 20 deposited with a passivation film were manufactured in the same manner as in Example 1 except that the cleaning gas supplied from the cleaning gas supply piping 13 in the deposit removal step was ammonia gas.

### (Comparative Example 1)

One hundred samples 20 deposited with a passivation film were manufactured in the same manner as in Example 1 except that only the passivation step was repeatedly performed without performing the deposit removal step.

For the samples 20 of Examples 1 to 8 and Comparative Example 1, every time the passivation step of each of the first to the 100th samples 20 was completed, the number of selenium particles adhering to a surface of each sample 20 was measured. A wafer inspection system SURFSCAN (registered trademark) 6240 manufactured by KLA-Tencor corporation was used to measure the number of the particles. Table 1 illustrates the measurement results.

**Table 1**

| | Temperature (°C) | Pressure (Pa) | Type of cleaning gas | Number of particles (pieces/m²) | | | | | | | | |
|---|---|---|---|---|---|---|---|---|---|---|---|---|
| | | | | Number of passivation steps (times) | | | | | | | | |
| | | | | 1 | 10 | 20 | 30 | 40 | 50 | 60 | 80 | 100 |
| Example 1 | 500 | 67000 | H₂ | 108 | 129 | 118 | 109 | 107 | 98 | 114 | 104 | 118 |
| Example 2 | 350 | 100 | H₂ | 120 | 149 | 169 | 178 | 185 | 231 | 250 | 277 | 309 |
| Example 3 | 20 | 67000 | H₂ | 110 | 250 | 392 | 524 | 664 | 748 | 842 | 904 | 984 |
| Example 4 | 800 | 67000 | H₂ | 99 | 103 | 103 | 94 | 89 | 92 | 99 | 108 | 120 |
| Example 5 | 500 | 20 | H₂ | 102 | 130 | 184 | 208 | 249 | 368 | 404 | 509 | 664 |
| Example 6 | 500 | 101000 | H₂ | 98 | 113 | 99 | 108 | 113 | 103 | 131 | 143 | 123 |
| Example 7 | 500 | 67000 | CH₄ | 103 | 99 | 94 | 108 | 123 | 113 | 98 | 118 | 108 |
| Example 8 | 500 | 67000 | NH₃ | 119 | 120 | 130 | 113 | 103 | 99 | 98 | 102 | 113 |
| Comparative Example 1 | - | - | - | 109 | 749 | 1048 | 2084 | 2908 | 3874 | 5209 | 7992 | 11782 |

As can be seen from Table 1, in Comparative Example 1 repeating only the passivation step without performing the deposit removal step, as the number of the passivation steps performed increased, i.e., as the number of the manufactured samples 20 deposited with the passivation film increased, the number of the particles adhering to the samples 20 increased, resulting in 2000 pieces/m² or more at the 30th time and 11000 pieces/m² or more at the 100th time.

On the other hand, in Examples 1 to 8 where the deposit removal step was performed after the passivation step, the number of particles adhering to the samples 20 was small. Even at the 100th passivation step, the number of the particles was about 100 pieces/m² in Example 1, about 300 pieces/m² in Example 2, and 1000 pieces/m² or less in the other Examples.

Thus, it has shown that performing the deposit removal step allows the passivation step to be performed repeatedly while keeping the number of adhering particles low without disassembling and washing the chamber.

### Reference Signs List

- 1:: Film deposition system
- 10:: Chamber
- 11:: Stage
- 12:: Passivation gas supply piping
- 13:: Cleaning gas supply piping
- 14:: Inert gas supply piping
- 15:: Exhaust piping
- 20:: Sample

## Claims

1. A deposit removal method comprising removing a selenium-containing deposit adhering to at least one of an inner surface of a chamber or an inner surface of piping connected to the chamber by reacting the deposit with a cleaning gas containing a hydrogen-containing compound gas.

2. The deposit removal method according to claim 1, wherein the cleaning gas is brought into contact with the deposit under conditions of a temperature of from 20°C to 800°C and a pressure of from 20 Pa to 101 kPa.

3. The deposit removal method according to claim 1 or 2, wherein the hydrogen-containing compound gas is at least one selected from a group consisting of hydrogen gas, hydrocarbon gas, and ammonia gas.

4. The deposit removal method according to claim 1 or 2, wherein the hydrogen-containing compound gas is hydrogen gas.

5. A film deposition method comprising:
a passivation step of supplying a passivation gas containing a selenium-containing compound gas to a chamber housing a substrate and reacting the substrate with the passivation gas to deposit a passivation film on a surface of the substrate; and
a deposit removal step of, after performing the passivation step, removing a selenium-containing deposit adhering to at least one of an inner surface of the chamber or an inner surface of piping connected to the chamber,
wherein the deposit removal step is performed by the deposit removal method according to any one of claims 1 to 4.

6. The film deposition method according to claim 5, wherein the selenium-containing compound gas is hydrogen selenide gas.
